# EUROPÄISCHE PATENTSCHRIFT

(11) **EP 3 824 697 B1**
(45) Veröffentlichungstag und Bekanntmachung des Hinweises auf die Patenterteilung: **12.10.2022**
(21) Anmeldenummer: 19734231.4
(22) Anmeldetag: 24.05.2019
(51) Int. Cl.: H05K 5/02, H05K 7/14, H05K 7/20, H02M 7/00

(54) **LEISTUNGSBAUGRUPPE MIT DEFINIERTEM UMLADEPFAD UND VERFAHREN ZUR HERSTELLUNG**
POWER MODULE WITH DEFINED RECHARGING PATH AND PRODUCTION METHOD
MODULE DE PUISSANCE À CHEMIN DE RECHARGE DÉFINI ET PROCÉDÉ DE FABRICATION

(30) Priorität: 25.05.2018 AT 504282018; 25.05.2018 AT 504292018; 25.05.2018 AT 504302018; 25.05.2018 AT 504312018; 13.09.2018 AT 507872018
(43) Veröffentlichungstag der Anmeldung: 26.05.2021
(73) Patentinhaber: Miba Energy Holding GmbH, 4663 Laakirchen (AT)
(72) Erfinder: NAGELMÜLLER, Martin, 4650 Edt bei Lambach (AT)
(74) Vertreter: Burger, Hannes
(86) Internationale Anmeldenummer: PCT/AT2019/060175
(87) Internationale Veröffentlichungsnummer: WO 2019/222784

(56) Entgegenhaltungen:
- US-A1- 2016 181 940

## Beschreibung

Die Erfindung betrifft ein Verfahren und eine Leistungsbaugruppe für einen Mittel- oder Hochspannungsumrichter, insbesondere einen Modularen Multilevelumrichter, wobei zumindest zwischen der Kühlvorrichtung und einem Busbar ein Verbindungselement zur Ausbildung eines definieren Umladepfads angeordnet ist.

Mittels Anwendung von leistungselektronischen Umrichtern erfolgt die Umwandlung von Wechselstrom in Gleichstrom bzw. umgekehrt. Dabei kommen häufig Wechselrichter (oder Modular Multilevel Converter-MMC) zum Einsatz. Derartige modulare Multilevel- Umrichter bestehen in der Regel aus einer Vielzahl in Reihe geschalteten Leistungsbaugruppen welche auch als Submodule bezeichnet werden können. Jede Leistungsbaugruppe kann dabei unabhängig von den anderen Leistungsbaugruppen geschaltet werden. Die Anordnung der Leistungsbaugruppen erfolgt häufig in einem Gestell bzw. Rack, wobei geringes Bauvolumen sowie Minimierung der Kosten und die Gewährleistung der Isolationsanforderungen vom Fachmann beachtet werden müssen. Dabei sind dem Fachmann eine Vielzahl von möglichen Anordnungen von Energiespeicherbaugruppen, Leistungshalbleiterbaugruppen, damit verbundene Steuervorrichtungen und insbesondere zur Kühlung dieser Elemente vorgesehene Kühlvorrichtungen bekannt.

Die zur Kontaktierung der Leistungsbaugruppen verwendeten Stromschienen sind häufig als Kupfer- oder Aluminiumleiter mit einer platten- oder stabförmigen Geometrie ausgebildet um die hohen Ströme verlustarm leiten zu können. Durch das sprunghaft wechselnde elektrische Potential von stromführenden Stromschienen kann es zu Umladevorgängen von elektrischer Ladung zwischen den Stromschienen und anderen, vor allem flächig ausgebildeten, Komponenten der Leistungsbaugruppe kommen, was als parasitäre Kapazitäten bezeichnet wird. Diese parasitären Kapazitäten können z.B. zu einem Gehäuse und/oder einer Kühlvorrichtung, oder auch zwischen anderen Komponenten ausgebildet werden und elektromagnetische Störaussendungen bewirken, wodurch die elektromagnetische Verträglichkeit (EMV) beeinträchtigt wird.

Die mit Spannung beaufschlagten Leistungsbaugruppen weisen in der Regel eine Vielzahl elektronischer Bauteile auf, welche vor der Inbetriebnahme auf ihre Funktionstüchtigkeit und Intaktheit der Isolation getestet werden müssen. Dies kann durch separates Testen der einzelnen Komponenten, wie etwa der einzelnen Leistungshalbleiter, vor dem Zusammenbau der Leistungsbaugruppe erfolgen. Dies birgt jedoch die Gefahr, dass während des Zusammenbaus eine Beschädigung einzelner Bauteile passiert oder dass elektrisch leitfähige Kleinteile in der Leistungsbaugruppe unbeabsichtigt verbleiben, welche im Betrieb zu einem undefinierten Stromentladepfad oder einer unerwünschten Teilentladung führen können. Im schlimmsten Fall kann dies zu einem Kurzschluss führen. Auch ein Testen bzw. Prüfen der gesamten Leistungsbaugruppe im Endzustand am Ende der mechanischen Fertigstellung ist in der Regel nur mit sehr hohem manuellen Aufwand möglich. Dies stellt einen erheblichen Nachteil für die kostengünstige Fertigung und Sicherung der Qualität dar.

Aufgabe der vorliegenden Erfindung war es, die Nachteile des Standes der Technik zu überwinden und eine Vorrichtung und ein Verfahren zur Verfügung zu stellen, mittels der/dem eine einfache, sichere und kostengünstige Ausbildung eines definierten Stromentladepfads vorgenommen werden kann. Eine weitere Aufgabe liegt darin, unvermeidliche parasitäre Entladeströme bzw. Ableitströme von unerwünschten Stellen der Leistungsbaugruppe fernzuhalten und somit EMV-Probleme, sowie Defekte und/oder strominduzierte Materialdegradationen zu reduzieren. Überdies liegt der Erfindung die Aufgabe zugrunde ein einfaches Verfahren zur Vermeidung oben genannter Probleme und zur Prüfung einer Leistungsbaugruppe, sowie der Erhöhung der Sicherheit und Qualität, und ferner der Reduktion der Herstellungs- bzw. Prüfkosten, bereit zu stellen.

Diese Aufgabe wird durch eine Vorrichtung, im Folgenden Leistungsbaugruppe, und ein Verfahren gemäß den Ansprüchen gelöst.

Die erfindungsgemäße Leistungsbaugruppe für einen Mittel- oder Hochspannungsumrichter, insbesondere einen Modularen Multilevelumrichter, umfasst zumindest eine Leistungshalbleiterbaugruppe, zumindest eine Energiespeicherbaugruppe, zumindest eine Kühlvorrichtung und zumindest zwei Stromschienen. Die Kühlvorrichtung ist elektrisch leitfähig ausgebildet und mit einem, zumindest die Leistungshalbleiterbaugruppe gegenüber der Umgebung abschirmenden, Schutzgehäuse verbunden, welches zumindest eine Einführöffnung zum Einführen und Befestigen eines Verbindungselements aufweist. An einer vorgebbaren Verbindungsposition ist ein elektrisch leitfähiges Verbindungselement, zur Ausbildung eines definierten Umladepfads, zwischen zumindest der Kühlvorrichtung und einem der Busbars angeordnet. Ein solcher Umladepfad kann auch als definierter Stromrückführpfad bzw. Entladepfad verstanden werden.

Zur Kontaktierung der Leistungsbaugruppe, insbesondere der Leistungshalbleiter bzw. der Leistungshalbleiterbaugruppe, sind Stromschienen vorgesehen. Stromanschlüsse der Stromschienen können dabei zur Kontaktierung und Leitung des Stromes in die Leistungsbaugruppe und/oder zu benachbart in Serien geschalteten Leistungsbaugruppen dienen und aus dem Schutzgehäuse hervorragen.

Eine Leistungshalbleitergruppe umfasst jeweils zumindest einen Leistungshalbleiter, wie etwa einen IGBT oder vergleichbare elektronische Bauteile. Eine Energiespeicherbaugruppe umfasst jeweils zumindest einen, bevorzugt als Kondensator ausgebildeten Energiespeicher.

Zumindest eine Leistungshalbleiterbaugruppe kann mit zwei elektrisch voneinander isolierten Busbars zur zumindest einen Energiespeicherbaugruppe gekoppelt sein. Die zur Beaufschlagung mit unterschiedlichem elektrischen Potential vorgesehenen Busbars sind elektrisch voneinander, bevorzugt über zumindest eine Isolationsschicht, getrennt angeordnet. Die Busbars können dabei als Teil eines Anschlussterminals zur elektrischen Verbindung der zumindest einen Energiespeicherbaugruppe mit zumindest einer Leistungsbaugruppe ausgebildet sein. Die Busbars können elektrisch über Isolatoren von der Kühlvorrichtung getrennt angeordnet sein. Die genaue Ausführung der elektrischen Komponenten, wie z.B. der Busbars, Isolatoren, Energiespeicherbaugruppe und/oder Leistungshalbleiterbaugruppe, kann vom Fachmann entsprechend den Erfordernissen der Leistungsbaugruppe optimiert werden.

Erfindungsgemäß wird durch das elektrische Verbindungselement die Kühlvorrichtung auf ein ähnliches oder im Wesentlichen gleiches elektrisches Potential wie die kontaktierte Busbar gebracht, wodurch der Einfluss parasitärer Kapazitäten auf ein definiertes Maß reduziert werden kann. Durch die Ausbildung der elektrisch leitfähigen Kühlvorrichtung wird eine sehr gute Wärmeleitfähigkeit und somit Wärmeabfuhr von der zumindest einen, bevorzugt thermisch kontaktierend angeordneten, Leistungshalbleiterbaugruppe erreicht. Durch die Ausbildung eines definierten Umladepfads zwischen zumindest der, bevorzugt metallischen, KühlVorrichtung und einer Busbar können somit unvermeidbare parasitäre Endladeströme von unerwünschten Stellen ferngehalten werden. Hierdurch kann eine verbesserte EMV-Aussendung erreicht werden. Ebenso kann auf diese Weise die Ausbildung von Defekten und/oder Materialdegradation an sensiblen Komponenten der Leistungsbaugruppe durch den Einfluss parasitärer Kapazitäten reduziert oder sogar vermieden werden.

Die erfindungsgemäß ausgebildete Leistungsbaugruppe bzw. das korrespondierende Verfahren können unter Umständen auch für Anwendungen im Niederspannungsbereich verwendet werden, bzw. vom Fachmann mit geringfügigen Maßnahmen für derartige Anwendungsfälle optimiert werden.

Analog zur oben genannten Ausführung der erfindungsgemäßen Leistungsbaugruppe, wird beim erfindungsgemäßen Verfahren als ein Verfahrensschritt zumindest eine derartige Leistungsbaugruppe bereitgestellt. Weitere Verfahrensschritte umfassen, das
- Befestigen bzw. Anordnen eines, zumindest die Leistungshalbleiterbaugruppe gegenüber der Umgebung abschließenden, Schutzgehäuses an der Kühlvorrichtung, welches zumindest eine Einführöffnung zum Einführen und Befestigen eines Verbindungselements aufweist,
- Ausbildung eines definierten Umladepfads durch Anbringen des Verbindungselements an einer vorgebbaren Verbindungsposition zwischen zumindest der Kühlvorrichtung und einer der Busbars durch die Einführöffnung.

Durch die erfindungsgemäß ausgebildete Leistungsbaugruppe, insbesondere dem, mit der Kühlvorrichtung verbundenen, Schutzgehäuse kann ein wirksamer Schutz vor externen Einflüssen, wie etwa Staub, Flüssigkeiten, etc., der zumindest einen Leistungshalbleiterbaugruppe erzielt werden. Umgekehrt kann das Schutzgehäuse auch nach außen hin, etwa bei einer explosionsartigen Zerstörung eines Leistungshalbleiters zur Abschirmung vor umherfliegenden Teilen dienen und hierzu im Wesentlichen abgeschlossen ausgebildet sein. Das Schutzgehäuse umfasst hierbei zumindest eine Einführöffnung, durch welche das Verbindungselement sicher eingeführt und befestigt werden kann. Von großem Vorteil hierbei ist, dass das Verbindungselement als letztes elektrisch wirksames Element in die Leistungsbaugruppe eingebracht wird. Somit kann eine Verschmutzung oder Beschädigung der Leistungsbaugruppe effizient vermieden werden.

Dies ist von besonderem Vorteil, als dass etwaige elektrische Prüfungen der Isolation und/oder auf Teilentladungsstrecken einzelner Komponenten oder auch der gesamten Leistungsbaugruppe vor dem Anbringen des Verbindungselements durchgeführt werden können. Derartige Prüfungen sind dem Fachmann unter anderem aus den beispielhaft angeführten Normen EN 50178, EN 60060-1 oder auch IEC 62501 bekannt.

Des Weiteren kann es zweckmäßig sein, wenn das Verbindungselement lösbar, bevorzugt als Schraub-, Steck- oder Rastelement, ausgebildet ist.

Diese mögliche Ausführungsform erlaubt eine einfache und sichere Montage, erlaubt die zeitweilige Entfernung des Verbindungselements bei Wartungsarbeiten, oder auch zu Prüfzwecken. Zum Abschluss derartiger Arbeiten kann das Verbindungselement wieder als letztes elektrisch wirksames Element platziert werden. Außerdem kann ein geschraubtes, gestecktes oder eingerastetes Verbindungselement einen eine gute Anbindung der Kühlvorrichtung an das Potential der Busbar gewährleisten. Ferner ist das Verbindungselement gut vor Korrosion geschützt.

Des Weiteren kann vorgesehen sein, dass das Verbindungselement einen Querschnitt aufweist, welcher um mehr als 10 %, bevorzugt mehr als 20 % größer ausgebildet ist, als ein für die Ausbildung des definierten Umladepfads und einer Ableitung parasitärer Entladeströme zumindest erforderlicher Mindestquerschnitt erforderlich ist.

Je nach Art und Größe der Leistungsbaugruppe können unterschiedlich hohe parasitäre Entladeströme auftreten, welche zur Ausbildung des Umladepfads vom Fachmann zur Auslegung des elektrisch leitfähigen Mindestquerschnitts des Verbindungselements berücksichtigt werden sollten. Es kann jedoch von erheblichem Vorteil sein, den elektrisch leitfähigen Querschnitt des Verbindungselements um 10 % und mehr, relativ zum genannten Mindestquerschnitt, zu erhöhen, da auf diese Weise zusätzlich zur Ausbildung eines definierten Umladepfads eine thermisch wirksame Anbindung an die Kühlvorrichtung ausgebildet werden kann. Somit kann auf einfache Weise eine zusätzliche Wärmeabfuhr zumindest vom kontaktierten Busbar zur Kühlvorrichtung vorgenommen werden. Zusätzlich kann ein am Busbar anliegendes Auflageelement des Verbindungselements, wie z.B. ein Schraubenkopf, eine gute Wärmeabfuhr in das Verbindungselement begünstigen, wodurch die Wärmeabfuhr verbessert werden kann.

Darüber hinaus kann vorgesehen sein, dass zumindest zwei Leistungshalbleiterbaugruppen an zumindest zwei normal auf eine Ebene der Busbars ausgerichteten Seiten der Busbars, bevorzugt gegenüberliegend, angeordnet sind.

Die Busbars sind als "flächige", also im Wesentlichen zweidimensional erstreckte, elektrische Leiter ausgebildet und geben somit eine Bezugsebene in zwei Raumrichtungen vor, wobei Seiten der Busbars demnach in die dritten Raumrichtung gerichtet sind. Die Anordnung von mehreren, also zumindest zwei Leistungshalbleitern, an zwei Seiten der Busbars oder auch um die Busbars herum kann dazu genutzt werden, dass die Leistungs- und/oder Stromverteilung im Wesentlichen in die dritte Raumrichtung homogenisiert wird. Eine derartige Anordnung kann die Länge der Strompfade und somit die undefinierte Ausbildung von parasitären Ableitströmen verringern und somit die EMV verbessern. Ebenso kann auf diese Weise die Ausbildung von parasitären Induktivitäten aufgrund von Symmetrieeffekten verringert werden.

Ferner kann vorgesehen sein, dass das Verbindungselement zumindest einen der Busbars mit der Kühlvorrichtung elektrisch verbindend und den zumindest einen anderen Busbar durchdringend und davon elektrisch isolierend angeordnet ist.

Diese Maßnahme erlaubt dem Fachmann eine große Anzahl an möglichen Verbindungspositionen, welche eine optimale Anordnung der jeweiligen elektrischen Komponenten, wie etwa den Leistungshalbleiterbaugruppen, Energiespeicherbaugruppen, Hilfsbaugruppen, etc., erlaubt, ohne dabei die Potentialanbindung der Kühlvorrichtung an eine Busbar zu behindern. Die elektrische Isolierung zur nicht-kontaktierten Busbar kann durch einen Luftspalt oder auch geeignete isolierende Materialien, wie etwa eine Kunststoffmuffe, sichergestellt werden. Dies kann die mechanische Stabilität zusätzlich erhöhen.

Vorteilhaft ist auch eine Ausprägung, gemäß welcher vorgesehen sein kann, dass das Verbindungselement in der Mitte der Ebene der Busbars angeordnet ist.

Auf diese Weise kann eine besonders effiziente Anordnung der zumindest einen, bevorzugt mehreren, Leistungshalbleitergruppe/n um die Busbars erfolgen. Diese Maßnahme fördert zudem die Symmetrie der angeordneten elektrischen Komponenten und erlaubt die Ausbildung in etwa gleich langer Strompfade, wodurch der Einfluss von parasitären Kapazitäten verringert und die EMV verbessert werden kann. Analog gilt dies für parasitäre Induktivitäten.

Gemäß einer Weiterbildung ist es möglich, dass zumindest eine der Busbars eine seitlich hervorstehende Anschlussfahne zur Kontaktierung des Verbindungselements aufweist.

Ein solcher Vorsprung einer Busbar ist kostengünstig und einfach zu realisieren und erlaubt darüber hinaus eine besonders einfache Montage ohne zusätzliche Isolationselemente zur nicht-kontaktierten Busbar vorsehen zu müssen.

Ferner kann es zweckmäßig sein, wenn ein, bevorzugt kanal- oder rohrförmiges, Einführelement, sich zumindest teilweise von der Einführöffnung des Schutzgehäuses in Richtung der nächstliegenden Busbar erstreckend ausgebildet ist.

Ein solches Einführelement kann das Einführen des Verbindungselements deutlich erleichtern. Da dieser Vorgang bei geschlossenem Schutzgehäuse vorgenommen werden soll, dient diese Maßnahme ferner der Verlustsicherung des Verbindungselements und kann die erforderliche Montagezeit verkürzen und komplizierte Einführ- oder Montagewerkzeuge obsolet machen.

Darüber hinaus kann vorgesehen sein, dass die Einführöffnung mittels eines Verschlusselements, bevorzugt einem Stopfen oder einer Schraube, verschlossen ist. Dieser Verschlussvorgang sollte während oder nach der Anbringung des Verbindungselements erfolgen.

Auf diese Weise kann das Schutzgehäuse effizient gegenüber der Umgebung vor Ein- oder Austritt von Flüssigkeiten, Staub und/oder Fremdkörpern verschlossen werden. Ein derartiges Verschlusselement kann im Sinne der vorliegenden Erfindung als, das letzte elektrisch nichtwirksame Element im Herstellungs- und/oder Wartungsprozess der Leistungsbaugruppe verstanden werden. Die Sicherheit im Betrieb, wie auch bei Wartungsarbeiten, kann hiermit deutlich erhöht werden.

Des Weiteren kann vorgesehen sein, dass das Schutzgehäuse elektrisch leitfähig und mit der Kühlvorrichtung elektrisch verbunden ausgebildet ist.

Das elektrisch leitfähige Schutzgehäuse kann somit auf einfache Weise auf das elektrische Potential der Kühlvorrichtung und der Busbar gebracht werden. Bei einem derartigen elektrisch leitfähigen Schutzgehäuse kann der Einfluss von parasitären Kapazitäten und unerwünschten Entladeströmen durch die elektrische Anbindung des Schutzgehäuses an die elektrisch leitfähige Kühlvorrichtung sehr gut kontrolliert bzw. sogar vermieden werden. Ein derartiges Schutzgehäuse kann auch foliert, beschichtet und/oder belackt sein und dennoch durch die elektrische Kontaktierung an die Kühlvorrichtung auf das im Wesentlichen gleiche elektrische Potential gebracht werden, wodurch unvermeidbare parasitäre Entladeströme gerichtet bzw. gelenkt werden können.

Gemäß einer besonderen Ausprägung ist es möglich, dass Schutzgehäuse mit der Kühlvorrichtung und einer der Busbars elektrisch verbunden ist.

Diese direkte Verbindung des Schutzgehäuses mit einem der Busbars und der elektrisch leitfähigen Kühlvorrichtung kann durch das elektrische Verbindungselement relativ einfach bewerkstelligt werden. In diesem Fall wird die vorgebbare Verbindungsposition an drei Punkten entlang des Verbindungselements gebildet. Auf diese Weise kann der definierte Umladepfad zwischen zumindest der Kühlvorrichtung und einem der Busbars sehr kurz gewählt werden. Überdies ist einfach vorstellbar, dass diese Maßnahme am Ende des Herstellungs- und/oder Prüfverfahrens der Leistungsbaugruppe besonders vorteilhaft ist.

Ferner kann vorgesehen sein, dass mit oder nach der Anbringung des Verbindungselements die Einführöffnung mittels eines Verschlusselements, bevorzugt einem Stopfen oder einer Schraube, verschlossen wird.

Durch das Anbringen eines "Verschlusses" für das Schutzgehäuse kann dem Eindringen von Schmutz, Flüssigkeiten, etc. in das Innere effizient vorgebeugt und somit die Betriebssicherheit erhöht werden. Außerdem kann durch das Verschließen des Schutzgehäuses der Explosionsschutz erhöht werden. Die Einführöffnung kann zur Aufnahme des Verschlusselements eine geeignete Form, wie etwa ein Gewinde oder dergleichen aufweisen. Ein separates Verschlusselement stellt somit im erfindungsgemäßen Verfahren das letzte elektrisch nicht-wirksame Bauteil bei der Fertigung und/oder Wartungsarbeiten der Leistungsbaugruppe dar, wodurch eine Beschädigung der elektrischen Komponenten z.B. beim Zusammenbau sehr gut vermieden werden kann. Abhängig von den Erfordernissen kann das Verschlusselement auch z.B. als teilisolierende Schraube ausgebildet sein, wodurch die elektrische Verbindung zwischen zumindest der Kühlvorrichtung und eine der Busbars gewährleistet sein kann, jedoch der Schaft und/oder Kopf der Schraube isolierend gegenüber dem Schutzgehäuse ausgebildet ist. In diesem Fall ist das elektrische Verbindungselement und das Verschlusselement einteilig ausgebildet.

Darüber hinaus kann vorgesehen sein, dass durch die Anbringung des Verbindungselements die Einführöffnung verschlossen wird und die Verbindungsposition zwischen zumindest der Kühlvorrichtung und einem der Busbars und dem Schutzgehäuse ausgebildet wird.

Mit dieser Maßnahme kann eine stabile Verbindungsposition an drei Punkten durch das Anbringen des Verbindungselements ausgebildet werden, wodurch ein zusätzlicher Umladepfad von der Busbar zum Schutzgehäuse ausgebildet wird. Das Verschließen und gleichzeitige elektrische Anbinden von Kühlvorrichtung, einer Busbar und dem Schutzgehäuse kann die Homogenität hinsichtlich der Umladeströme erhöhen, was wiederum eine verbesserte EMV bewirkt. Zudem kann diese Maßnahme als abschließender Verfahrensschritt durchgeführt werden und eine relativ schnelle, verlustsichere Anbringung des Verbindungselementes gewährleistet werden.

Vorteilhaft ist auch eine Ausprägung, gemäß welcher vorgesehen sein kann, dass vor der Befestigung des Schutzgehäuse eine erste elektrische Prüfung der Leistungsbaugruppe durch Anlegen einer ersten Prüfspannung an zumindest einer vorgebbaren Isolationsstrecke durchgeführt wird.

Als Isolationsstrecke kann im Rahmen der vorliegenden Erfindung ein elektrischer Pfad verstanden werden, welcher nach Fertigstellung der Leistungsbaugruppe auf einem gemeinsamen vorgesehenen elektrischen Potential liegen soll. Sinngemäß kann daher eine derartige Isolationsstrecke ein oder auch mehrere elektrische Komponenten bzw. Baugruppen oder Bauteile umfassen. Eine solche erste elektrische Prüfung von Isolationsstrecken kann zur Kontrolle einer Basisisolierung genutzt werden, wobei auf sehr einfache Weise etwaige Kurzschlüsse und/oder lose Teile detektiert werden können. Der Vorteil dieser Maßnahme ist, dass eine derartige Prüfung relativ einfach und insbesondere automatisiert durchgeführt werden kann bevor die Leistungsbaugruppe fertiggestellt wird und das elektrische Verbindungselement angebracht wird. Bevorzugt wird eine derartige Prüfung im Bereich von wenigen Volt, wie etwa 5 bis 10 V, durchgeführt.

Ferner kann es zweckmäßig sein, wenn nach der ersten Prüfung und/oder nach der Befestigung des Schutzgehäuse eine zweite elektrische Prüfung der Leistungsbaugruppe durch Anlegen einer, relativ zur ersten Prüfspannung erhöhten, zweiten Prüfspannung an zumindest einer vorgebbaren Isolationsstrecke durchgeführt wird.

Eine derartige zweite Prüfung kann zur Prüfung der elektrischen Verbindungen und Isolationsstrecken auf Belastbarkeit genutzt werden und wird sinnvollerweise erst nach der ersten Prüfung durchgeführt um Beschädigungen der Leistungsbaugruppe zu vermeiden. Dies dient der Kontrolle der Funktionsisolierung und wird daher bevorzugt im Bereich von 100 V bis etwa 400 V durchgeführt. Vorteilhafterweise wird diese Prüfung vor dem Anbringen des elektrischen Verbindungselements durchgeführt.

Darüber hinaus kann vorgesehen sein, dass zumindest zwischen eine der Busbars und der Kühlvorrichtung und/oder dem Schutzgehäuse eine Kontrollprüfung hinsichtlich der Funktionstüchtigkeit und/oder des Vorhandenseins des elektrischen Verbindungselements vorgenommen wird.

Diese Maßnahme kann als eine Art Endprüfung vorgenommen werden um die Funktionstüchtigkeit des elektrischen Verbindungselements zu prüfen. Auf diese Weise kann relativ einfach die Qualität der Leistungsbaugruppe sichergestellt werden und die Sicherheit im späteren Betrieb gewährleistet werden. Bevorzugt wird diese Kontrollprüfung automatisiert durchgeführt.

Entsprechend einer vorteilhaften Weiterbildung kann vorgesehen sein, dass die Kühlvorrichtung als eine lastabtragende, kühlmitteldurchströmbare Kühlplatte ausgebildet ist.

Bei dieser Ausführungsform wird die Kühlvorrichtung als lastabtragendes Konstruktionselement in Form einer Kühlplatte ausgebildet, wobei ein großer Vorteil darin liegt, dass eine Stützfunktion der Leistungsbaugruppe am Gestell ausgeübt werden kann und die Kühlplatte gleichzeitig eine Aufnahmeplattform für sämtliche an der Kühlvorrichtung bzw. Kühlplatte angeordneten Baugruppen bildet. Die Kühlplatte dient somit als eine Art Aufbauplattform zur Aufnahme der Energie-, Leistungshalbleiterbaugruppen und etwaiger weiterer Komponenten. Derartige Komponenten können z.B. in Form einer Hilfsbaugruppe an der Kühlplatte angeordnet sein und etwa eine Steuervorrichtung, Netzteile, Widerstände und dergleichen umfassen. Je nach Aufbau und Typ des Mittel- oder Hochspannungsumrichters kann es dabei von Vorteil sein, zumindest eine Leistungshalbleiterbaugruppe an einer Seite, wie etwa der Oberseite, der Kühlplatte anzuordnen und die zumindest eine Energiespeicherbaugruppe an der gegenüberliegenden Seite, wie etwa der Unterseite, der Kühlplatte anzuordnen. Analog hierzu sind auch "stehende" Kühlplatten denkbar. Ferner kann diese Ausbildung dazu beitragen die lokale Wärmeabfuhr der elektrischen Komponenten, insbesondere der Leistungshalbleiterbaugruppe, sehr effizient zu gewährleisten und gleichzeitig eine platzsparende Anordnung mehrerer Leistungsbaugruppen im Gestell des Mittel- oder Hochspannungsumrichters zu ermöglichen. Die Aufnahmeräume und/oder Stützflächen auf denen sich die Kühlplatte abstützt, sind voneinander elektrisch isoliert um Kurzschlüsse zwischen einzelnen Leistungsbaugruppen zu vermeiden.

Insbesondere kann es vorteilhaft sein, wenn die Energiespeicherbaugruppe an einer der zumindest einen Leistungshalbleiterbaugruppe und den zumindest zwei Busbars gegenüberliegenden Seite der Kühlplatte angeordnet ist, wobei die Kühlplatte eine Durchgangsöffnung zur Verbindung der Energiespeicherbaugruppe mit der zumindest einen Leistungshalbleiterbaugruppe aufweist.

Auf diese Weise kann die Kühlplatte eine Wirkung als Explosionsschutz zwischen den elektrischen Komponenten, welche an den jeweiligen Seiten angeordnet sind ausbilden. Außerdem wird durch die, bevorzugt in zumindest einer Richtung, mittig angeordnete Durchgangsöffnung eine relativ einfache elektrische Verbindung der Leistungshalbleiterbaugruppe zur Energiespeicherbaugruppe, bevorzugt über ein Anschlussterminal welches die Busbars umfasst, ermöglicht. Hierdurch werden einerseits sehr kurze elektrische Verbindungsstrecken zwischen den stromführenden Komponenten und in der Folge eine Reduktion und/oder Homogenisierung von parasitären Kapazitäten und/oder Induktivitäten ermöglicht. Somit kann diese Maßnahme zu einer Verbesserung der EMV erheblich beitragen.

Zum besseren Verständnis der Erfindung wird diese anhand der nachfolgenden Figuren näher erläutert.

Es zeigen jeweils in stark vereinfachter, schematischer Darstellung:
- Fig. 1: schematische Darstellung einer Leistungsbaugruppe mit elektrischen Komponenten und Verbindungselement;
- Fig. 2: schematische Schrägansicht einer möglichen Anordnung elektrischer Komponenten an der Kühlvorrichtung mit unterschiedlichen möglichen Verbindungspositionen des Verbindungselements;
- Fig. 3: verschiedene mögliche Ausführungsformen der Leistungsbaugruppe mit Verbindungspositionen die Busbars durchdringend (a),(d) und/oder mittig angeordnet (b), oder an einer Anschlussfahne (c);
- Fig. 4: schematische Schrägansicht einer möglichen Ausführungsform einer Leistungsbaugruppe mit beidseitig an der Kühlvorrichtung angeordneten Energie- und Leistungshalbleiterbaugruppen.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

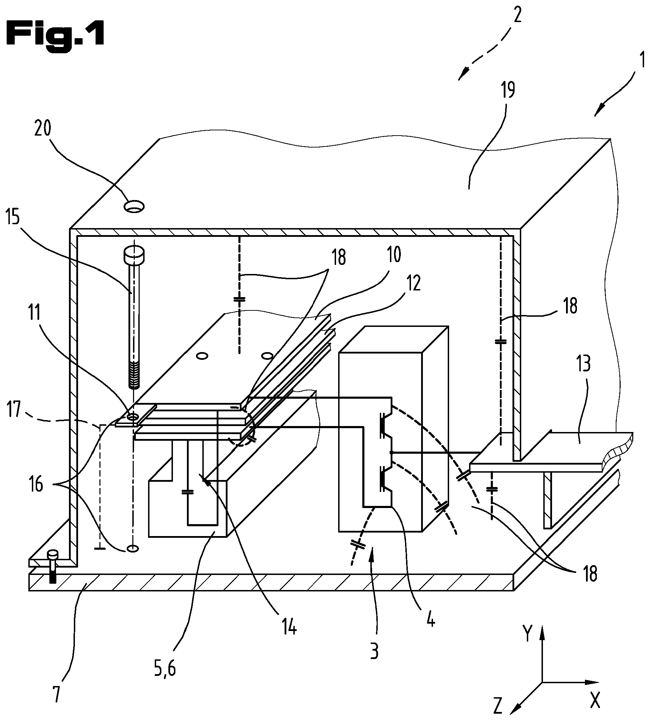

In Fig. 1 ist eine schematische Darstellung einer erfindungsgemäßen Leistungsbaugruppe 1 für nicht eigens dargestellten einen Mittel- oder Hochspannungsumrichter 2 gezeigt. Die Leistungsbaugruppe 1 umfasst zumindest eine Leistungshalbleiterbaugruppe 3 sowie zumindest eine Energiespeicherbaugruppe 5 sowie zumindest eine Kühlvorrichtung 7. Die Leistungshalbleiterbaugruppe 3 kann zur Energiespeicherbaugruppe 5, beispielsweise über Busbars 10 und/oder ein Anschlussterminal 14 verbunden werden. Derartige Anordnungen sind dem Fachmann im Detail bekannt und werden hier nur schematisch dargestellt. Die Stromversorgung und/oder Kontaktierung mit externen Leistungsanschlüssen wird schematisch mittels einer Stromschiene 13 angedeutet. Die in der Regel flächig ausgebildeten Busbars 10 sind durch eine Isolationsschicht 12 voneinander getrennt. Das hochfrequent wechselnde elektrische Potential der Stromschienen 13 kann zur ungewollten Speicherung elektrischer Ladung zwischen den Stromschienen 13 und anderen vor allem flächig ausgebildeten Komponenten der Leistungsbaugruppe 1 führen. Dies wird unter anderem als parasitäre Kapazität 18 bezeichnet und ist mit den entsprechenden Symbolen und strichlierten Verbindungslinien zwischen möglichen elektrischen Komponenten der Leistungsbaugruppe 1, an welchen derartige parasitäre Kapazitäten 18 auftreten können, angedeutet.

Die schematische Darstellung in Fig. 1 ermöglicht das Funktionsprinzip der erfindungsgemäß ausgebildeten Leistungsbaugruppe 1 nachzuvollziehen, in welcher eine Kühlvorrichtung 7 elektrisch leitfähig ausgebildet ist und an welcher die zumindest eine Leistungshalbleiterbaugruppe 3 bevorzugt direkt wärmeübertragend angeordnet ist. Die Leistungshalbleiterbaugruppe 3 umfasst zumindest einen Leistungshalbleiter 4, wie etwa einen IGBT oder ähnliche geeignete elektronische Bauteile. Zum Schutz gegenüber der Umgebung ist ein Schutzgehäuse 19 mit der Kühlvorrichtung 7 verbunden. Zur Verbesserung der elektromagnetischen Verträglichkeit wird erfindungsgemäß ein definierter Umladepfad 17 bzw. Strompfad zwischen zumindest der Kühlvorrichtung 7 und einer der Busbars 10 mittels eine Verbindungselements 15 ausgebildet. Der strichliert dargestellte Umladepfad 17 wird an einer geeigneten Verbindungsposition 16 mittels eines Verbindungselements 15 ausgebildet. Erfindungsgemäß erfolgt die Anbringung des Verbindungselements 15 als letztes, elektrisch wirksames Element der Leistungsbaugruppe 1. Dies wird durch eine Einführöffnung 20 im Schutzgehäuse 19 ermöglicht. Auf diese Weise kann ein definierter Strom- bzw. Umladepfad 17 für unvermeidliche, parasitäre Entladeströme geschaffen werden und der Einfluss parasitärer Kapazitäten 18 kann an unerwünschten Stellen weitestgehend reduziert oder sogar vermieden werden, wodurch die EMV sowie Defekte und/oder Materialdegradation einzelner Komponenten reduziert werden können.

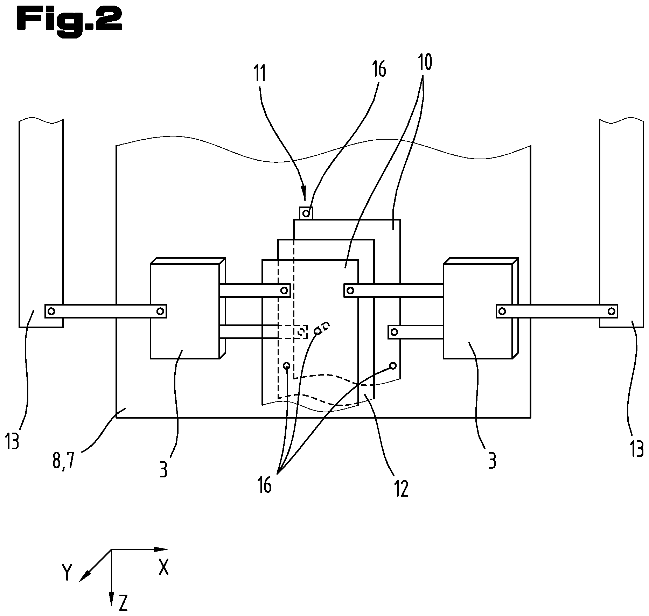

Das Prinzip der Ausbildung eines definierten Umladepfads 17 durch Anbringen des Verbindungselements 15 an einer vorgebbaren Verbindungsposition 16 aus Fig. 1 ist auf die Fig. 2 bis 4 übertragbar und wird nachfolgend an einigen möglichen Ausführungsbeispielen weiter erläutert.

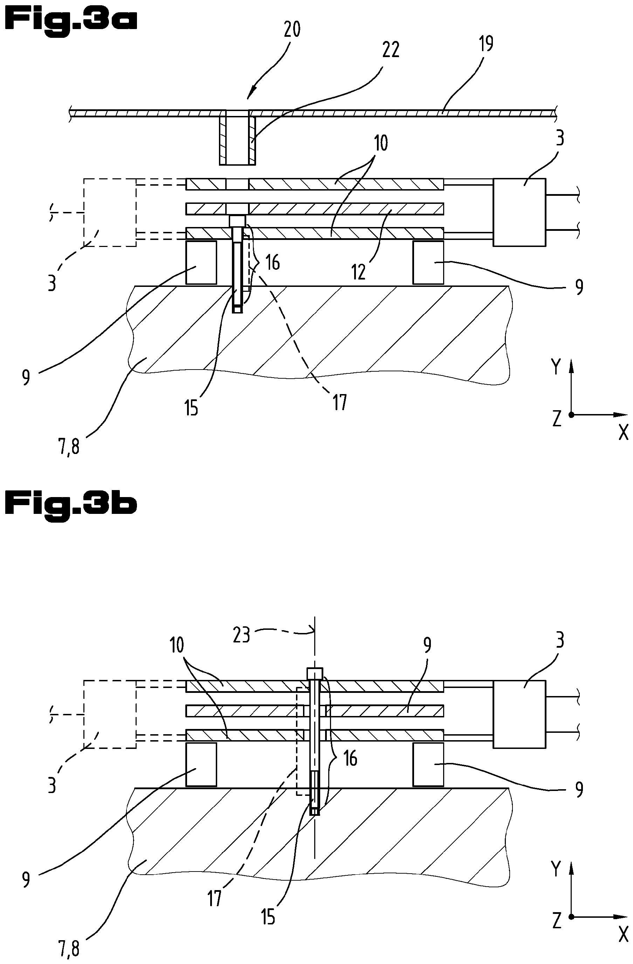

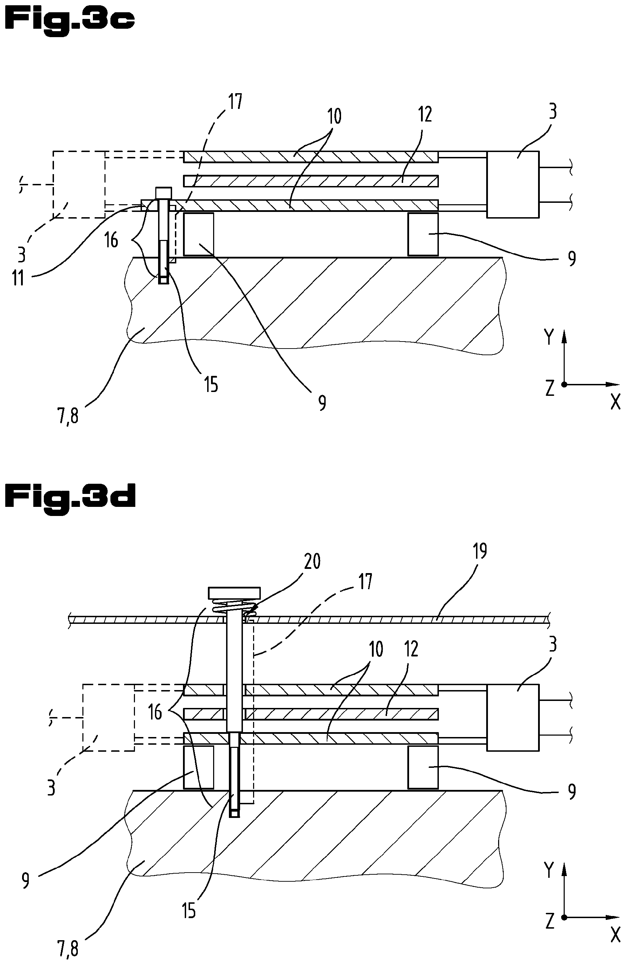

Das in Fig. 1 als Schraube beispielhaft gezeigte Verbindungselement 15 kann, wie in Fig. 2 in Zusammenschau mit Fig. 3 zumindest einen der Busbars 10 mit der Kühlvorrichtung 7 elektrisch verbindend angeordnet sein, wobei zumindest einer der Busbars 10 kontaktiert wird. In Fig. 2 sind zwei Leistungshalbleiterbaugruppen 3 beispielhaft an gegenüberliegenden Seiten der Busbars 10 angeordnet. Eine derartige Anordnung ermöglicht kurze elektrische Leitungspfade und verbessert auf diese Weise die elektromagnetische Verträglichkeit durch Verringerung parasitärer Induktivitäten. In Fig. 2 ist ferner ersichtlich, dass die Verbindungsposition 16 zwischen der Kühlvorrichtung 7 bzw. Kühlplatte 8 zu zumindest einem der Busbars an unterschiedlichen Positionen möglich ist. Beispielsweise kann die Verbindungsposition 16 an einer seitlich an einer der Busbars 10 hervorstehenden Anschlussfahne 11 zur Kontaktierung des Verbindungselements 15 zur Kühlplatte 8 ausgebildet sein.

Unter Verweis auf die vorangegangene Diskussion von Fig. 1 und 2 sind weitere beispielhafte Ausführungsformen von erfindungsgemäßen Leistungsbaugruppen 1 in den Fig. 3a bis 3d dargestellt. Die Busbars 10 können voneinander durch eine Isolationsschicht 12, bzw. zur Kühlvorrichtung hin durch Isolatoren 9, abgeschirmt und/oder abgestützt sein.

Fig. 3a stellt eine schematische Querschnittsansicht dar, in welcher die in Vertikalrichtung untere Busbar 10 durch das Verbindungselement 15 zur leitfähigen Kühlvorrichtung bzw. Kühlplatte 8 verbunden ist Aus der Darstellung in Fig. 3a kann weiters ersehen werden, dass an die Einführöffnung 20 des Schutzgehäuses 19 in Richtung der Kühlvorrichtung ein Einführelement 22 ausgebildet ist. Dieses bevorzugt rohrförmig oder kanalförmig ausgebildete Einführelement 22 ermöglicht das verlustsichere Einführen und Befestigen des Verbindungselements 15.

In Fig. 3b wird eine bevorzugte mögliche Ausführungsform einer Verbindungsposition 16 angedeutet, wobei die Verbindungsposition in der Mitte 23 in einer Ebene der Busbars 10 angeordnet ist. In diesem Fall ist die in Vertikalrichtung zuoberst liegende Busbar 10 mit der Kühlvorrichtung 7 bzw. Kühlplatte 8 über das Verbindungselement 15 verbunden.

Eine weitere mögliche Anordnung des Verbindungselements 15 ist aus der Schnittdarstellung in Fig. 3c ersichtlich, wobei die Verbindungsposition 16 zwischen einer Busbar 10 und der Kühlvorrichtung 7 mittels einer seitlich an der Busbar hervorragenden Anschlussfahne 11 ausgeführt ist.

In Fig. 3d ist eine weitere und gegebenenfalls für sich eigenständige Ausführungsform der erfindungsgemäßen Leistungsbaugruppe 1 gezeigt. In der beispielhaften Darstellung von 3d ist das Schutzgehäuse elektrisch leitfähig ausgebildet und mit der Kühlvorrichtung 7 und einer der Busbars elektrisch verbunden. Die vorgebbare Verbindungsposition 16 umfasst in diesem Fall drei Punkte entlang des Verbindungselements 15 an denen elektrische Kontakte ausgebildet werden. In der dargestellten Situation wird zugleich mit der Anbringung des Verbindungselements 15 die Einführöffnung 20 des Schutzgehäuses 19 verschlossen. Nicht dargestellt ist eine Situation in welcher das elektrische Verbindungselement 15 als teilisolierende Schraube ausgebildet ist, wobei im Bereich des Schafts und/oder Kopfes der Schraube eine Isolation gegenüber dem Schutzgehäuse ausgebildet ist. In beiden Fällen ist jedoch das Verbindungselement 15 und ein zum Verschluss der Einführöffnung 20 vorgesehenes Verschlusselement 21 einteilig ausgebildet.

Die Verbindungselemente 15 können einen elektrisch leitfähigen Querschnitt aufweisen, welcher gleichzeitig zu einer gezielten Wärmeabfuhr an die Kühlvorrichtung beiträgt. Insbesondere kann es von Vorteil sein, wenn der wirksame Querschnitt um zumindest 10 % größer als der erforderliche Mindestquerschnitt für die elektrische Anbindung und Ausbildung des definierten Umladepfads 17 ausgebildet ist. Überdies kann bei z.B. schraubenartig ausgebildeten Verbindungselementen 15, wie z.B. in Fig.3a-3c ersichtlich, ein verbreiterter Schraubenkopf für eine verbesserte Auflage bzw. Kontaktierung der Busbar 10 genutzt werden, wodurch eine erhöhte Wärmeaufnahme bzw. Wärmeabfuhr begünstigt werden kann.

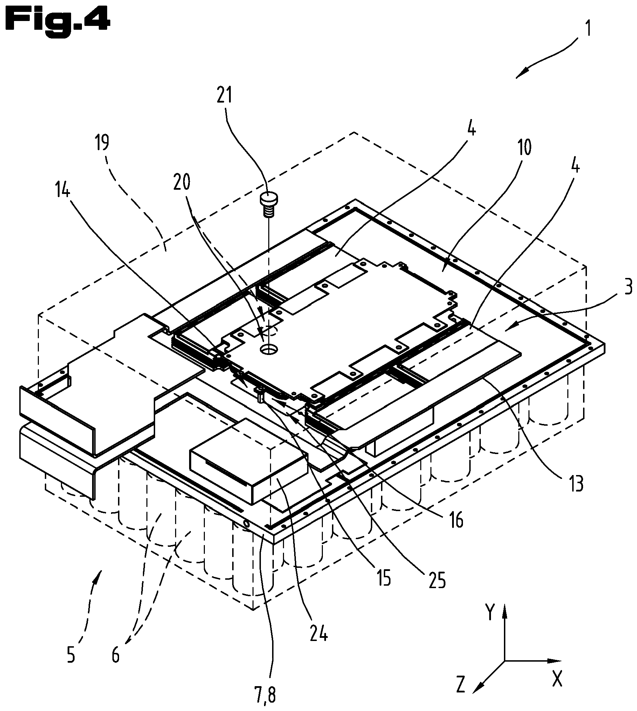

In Fig. 4 ist eine schematische Schrägansicht einer Leistungsbaugruppe 1 dargestellt. In der gewählten Darstellung ist ersichtlich, dass die zumindest eine Leistungshalbleiterbaugruppe 3 sowie die zumindest eine Energiespeicherbaugruppe 5 an gegenüberliegenden Seiten der Kühlplatte 8 angeordnet sind. Eine Verbindung der Energiespeicherbaugruppe 5 mit der Leistungshalbleiterbaugruppe 3 und/oder einer Hilfsbaugruppe 24 ist durch die Ausbildung einer die Kühlplatte 8 durchdringenden Durchgangsöffnung 25 möglich. Im Bereich dieser Durchgangsöffnung 25 kann sich bevorzugt ein Anschlussterminal 14 zur Verbindung der elektrischen Komponenten befinden. Eine derartige Situation ist besonders in Verbindung mit einer in Querrichtung und/oder Längsrichtung symmetrischen Anordnung der Komponenten der Leistungsbaugruppe 1, wie etwa in Fig. 2 schematisch angedeutet, besonders vorteilhaft. Durch eine oder mehrere Durchgangsöffnungen 25 können die elektrischen Verbindungspfade relativ kurz gewählt werden.

Des Weiteren kann aus Fig. 4 ersehen werden, dass zum Verschluss der Einführöffnung 20 des Schutzgehäuses 19 ein separates Verschlusselement 21 vorgesehen sein kann. Ein derartiges Verschlusselement 21 ist als elektrisch nicht wirksames Element vorgesehen und dient dem Abschluss des Schutzgehäuses 19 gegenüber der Umgebung.

Für den Fachmann ist aus den Darstellungen der Fig. 1 bis 4 leicht ersichtlich, dass erfindungsgemäß etwaige elektrische Prüfungen an diversen, vorgebbaren Isolationsstrecken einfach durchgeführt werden können, bevor und/oder nachdem die Befestigung des Schutzgehäuses 19 erfolgt ist.

Über dies kann in Fig. 4 ersehen werden, dass eine symmetrische Anordnung der elektrischen Komponenten die Ausbildung in etwa gleich langer Strompfade ermöglicht. Dies begünstigt die Reduktion des Einflusses parasitärer Kapazitäten und/oder Induktivitäten und verbessert die EMV. Dies ist von speziellem Vorteil bei flächig ausgebildeten Busbars 10 und/oder Stromschienen 13, welche gegenüber einem Schutzgehäuse 19 und/oder der elektrisch leitfähigen Kühlplatte 8 zur Ausbildung parasitärer Kapazitäten 18 neigen würden.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Leistungsbaugruppe
- 2: Mittel- oder Hochspannungsumrichter
- 3: Leistungshalbleiterbaugruppe
- 4: Leistungshalbleiter
- 5: Energiespeicherbaugruppe
- 6: Energiespeicher
- 7: Kühlvorrichtung
- 8: Kühlplatte
- 9: Isolator
- 10: Busbar
- 11: Anschlussfahne
- 12: Isolations schicht
- 13: Stromschiene
- 14: Anschlussterminal
- 15: Verbindungselement
- 16: Verbindungsposition
- 17: Umladepfad
- 18: parasitäre Kapazität
- 19: Schutzgehäuse
- 20: Einführöffnung
- 21: Verschlusselement
- 22: Einführelement
- 23: Mitte der Busbarebene
- 24: Hilfsbaugruppe
- 25: Durchgangsöffnung

## Patentansprüche

1. Leistungsbaugruppe (1) für einen Mittel- oder Hochspannungsumrichter (2), insbesondere einen Modularen Multilevelumrichter, umfassend:
- zumindest eine Leistungshalbleiterbaugruppe (3),
- zumindest eine Energiespeicherbaugruppe (5),
- zumindest eine Kühlvorrichtung (7), welche elektrisch leitfähig ausgebildet ist,
- zumindest zwei Busbars (10), wobei
die Kühlvorrichtung (7) mit einem, zumindest die Leistungshalbleiterbaugruppe (3) gegenüber der Umgebung abschirmenden, Schutzgehäuse (19) verbunden ist,
**dadurch gekennzeichnet, dass**
das Schutzgehäuse (19) zumindest eine Einführöffnung (20) zum Einführen und Befestigen eines elektrisch leitfähigen Verbindungselements (15) bei geschlossenem Schutzgehäuse (19) aufweist,
und an einer vorgebbaren Verbindungsposition (16) das elektrisch leitfähige Verbindungselement (15), zur Ausbildung eines definierten Umladepfads (17), zwischen zumindest der Kühlvorrichtung (7) und einem der Busbars (10) angeordnet ist.

2. Leistungsbaugruppe (1) nach Anspruch 1 **dadurch gekennzeichnet, dass** das Verbindungselement (15) lösbar, bevorzugt als Schraub-, Steck- oder Rastelement, ausgebildet ist.

3. Leistungsbaugruppe (1) nach Anspruch 1 oder 2 **dadurch gekennzeichnet, dass** das Verbindungselement (15) einen Querschnitt aufweist, welcher um mehr als 10 %, bevorzugt mehr als 20 % größer ausgebildet ist, als ein für die Ausbildung des definierten Umladepfads (17) und einer Ableitung parasitärer Entladeströme zumindest erforderlicher Mindestquerschnitt erforderlich ist.

4. Leistungsbaugruppe (1) nach einem der vorhergehenden Ansprüche **dadurch gekennzeichnet, dass** zumindest zwei Leistungshalbleiterbaugruppen (3) an zumindest zwei normal auf eine Ebene der Busbars (10) ausgerichteten Seiten der Busbars (10), bevorzugt gegenüberliegend, angeordnet sind.

5. Leistungsbaugruppe (1) nach einem der vorhergehenden Ansprüche **dadurch gekennzeichnet, dass** das Verbindungselement (15) zumindest einen der Busbars (10) mit der Kühlvorrichtung (7) elektrisch verbindend und den zumindest einen anderen Busbar (10) durchdringend und davon elektrisch isolierend angeordnet ist.

6. Leistungsbaugruppe (1) nach Anspruch 5 **dadurch gekennzeichnet, dass** das Verbindungselement (15) in der Mitte (23) der Ebene der Busbars (10) angeordnet ist.

7. Leistungsbaugruppe (1) nach einem der Ansprüche 1 bis 4 **dadurch gekennzeichnet, dass** zumindest eine der Busbars (10) eine seitlich hervorstehende Anschlussfahne (11) zur Kontaktierung des Verbindungselements (15) aufweist.

8. Leistungsbaugruppe (1) nach einem der vorhergehenden Ansprüche **dadurch gekennzeichnet, dass** ein, bevorzugt als kanal- oder rohrförmiges, Einführelement (22), sich zumindest teilweise von der Einführöffnung (20) des Schutzgehäuses (19) in Richtung der nächstliegenden Busbar (10) erstreckend ausgebildet ist.

9. Leistungsbaugruppe (1) nach einem der vorhergehenden Ansprüche **dadurch gekennzeichnet, dass** die Einführöffnung (20) mittels eines Verschlusselements (21), bevorzugt einem Stopfen oder einer Schraube, verschlossen ist.

10. Leistungsbaugruppe (1) nach einem der vorhergehenden Ansprüche **dadurch gekennzeichnet, dass** das Schutzgehäuse (19) elektrisch leitfähig und mit der Kühlvorrichtung (7) elektrisch verbunden ausgebildet ist.

11. Leistungsbaugruppe (1) nach Anspruch 10 **dadurch gekennzeichnet, dass** das Verbindungselement (15) derart angeordnet ist, dass Schutzgehäuse (19) mit der Kühlvorrichtung (7) und einer der Busbars (10) elektrisch verbunden ist.

12. Leistungsbaugruppe (1) nach einem der vorhergehenden Ansprüche **dadurch gekennzeichnet, dass** die Kühlvorrichtung (7) als eine lastabtragende, kühlmitteldurchströmbare Kühlplatte (8) ausgebildet ist.

13. Leistungsbaugruppe (1) nach Anspruch 12 **dadurch gekennzeichnet, dass** die Energiespeicherbaugruppe (5) an einer der zumindest einen Leistungshalbleiterbaugruppe (3) und den zumindest zwei Busbars (10) gegenüberliegenden Seite der Kühlplatte (8) angeordnet ist, wobei die Kühlplatte (8) eine Durchgangsöffnung (25) zur Verbindung der Energiespeicherbaugruppe (5) mit der zumindest einen Leistungshalbleiterbaugruppe (3) aufweist.

14. Verfahren zur Herstellung einer Leistungsbaugruppe (1), insbesondere für einen Mittel- oder Hochspannungsumrichter (2), umfassend die Verfahrensschritte:
- Bereitstellung einer Leistungsbaugruppe (1) nach einem der Ansprüche 1 bis 13, zumindest umfassend:
- Befestigen eines, zumindest die Leistungshalbleiterbaugruppe (3) gegenüber der Umgebung abschließenden, Schutzgehäuses (19) an der Kühlvorrichtung (7), welches zumindest eine Einführöffnung (20) zum Einführen und Befestigen eines Verbindungselements (15) aufweist,
- Ausbildung eines definierten Umladepfads (17) durch Anbringen des Verbindungselements (15) an einer vorgebbaren Verbindungsposition (16) zwischen zumindest der Kühlvorrichtung (7) und einer der Busbars (10) durch die Einführöffnung (20) bei geschlossenem Schutzgehäuse (19).

15. Verfahren nach Anspruch 14 **dadurch gekennzeichnet, dass** mit oder nach der Anbringung des Verbindungselements (15) die Einführöffnung (20) mittels eines Verschlusselements (21), bevorzugt einem Stopfen oder einer Schraube, verschlossen wird.

16. Verfahren nach Anspruch 15 **dadurch gekennzeichnet, dass** durch die Anbringung des Verbindungselements (15) die Einführöffnung (20) verschlossen wird und die Verbindungsposition (16) zwischen zumindest der Kühlvorrichtung (7) und einem der Busbars (10) und dem Schutzgehäuse (19) ausgebildet wird.

17. Verfahren nach einem der Ansprüche 14 bis 16 **dadurch gekennzeichnet, dass** vor der Befestigung des Schutzgehäuse (19) eine erste elektrische Prüfung der Leistungsbaugruppe (1) durch Anlegen einer ersten Prüfspannung an zumindest einer vorgebbaren Isolationsstrecke durchgeführt wird.

18. Verfahren nach Anspruch 17 **dadurch gekennzeichnet, dass** nach der ersten Prüfung und/oder nach der Befestigung des Schutzgehäuse (19) eine zweite elektrische Prüfung der Leistungsbaugruppe (1) durch Anlegen einer, relativ zur ersten Prüfspannung erhöhten, zweiten Prüfspannung an zumindest einer vorgebbaren Isolationsstrecke durchgeführt wird.

19. Verfahren nach einem der Ansprüche 14 bis 18 **dadurch gekennzeichnet, dass** zwischen einer der Busbars (10) und der Kühlvorrichtung (7) und/oder dem Schutzgehäuse (19) eine Kontrollprüfung hinsichtlich der Funktionstüchtigkeit und/oder des Vorhandenseins des Verbindungselements (15) vorgenommen wird.

## Claims

1. A power module (1) for a medium or high voltage converter (2), in particular a modular multilevel converter, comprising:
- at least one power semiconductor module (3),
- at least one energy storage module (5),
- at least one cooling device (7), which is formed to be electrically conductive,
- at least two busbars (10), wherein
the cooling device (7) is connected to a protective housing (19) shielding at least the power semiconductor module (3) from the environment,
**characterized in that**
the protective housing (19) has at least one insertion opening (20) for inserting and fastening an electrically conductive connecting element (15) when the protective housing (19) is closed,
and the electrically conductive connecting element (15) is arranged at a predefinable connection position (16) between at least the cooling device (7) and one of the busbars (10) for forming a defined charge-reversal path (17).

2. The power module (1) according to claim 1, **characterized in that** the connecting element (15) is formed to be releasable, preferably as a screw element, plug element or locking element.

3. The power module (1) according to claim 1 or 2, **characterized in that** the connecting element (15) has a cross-section which is formed to be more than 10%, preferably more than 20% larger than a minimum cross-section required for forming the defined charge-reversal path (17) and for diverting parasitic discharge currents.

4. The power module (1) according to one of the preceding claims, **characterized in that** at least two power semiconductor modules (3) are arranged on at least two sides of the busbar (10) with an orientation normal to a plane of the busbar (10), preferably opposite.

5. The power module (1) according to one of the preceding claims, **characterized in that** the connecting element (15) is arranged so as to electrically connect at least one of the busbars (10) to the cooling device (7) and to go through at least one other busbar (10) and to electrically insulate from it.

6. The power module (1) according to claim 5, **characterized in that** the connecting element (15) is arranged at the center (23) of the plane of the busbar (10).

7. The power module (1) according to one of claims 1 to 4, **characterized in that** at least one of the busbars (10) has a laterally protruding connection lug (11) for contacting the connecting element (15).

8. The power module (1) according to one of the preceding claims, **characterized in that** an insertion element (22), preferably having a channel or pipe shape, is formed so as to extend at least partially from the insertion opening (20) of the protective housing (19) in the direction of the nearest busbar (10).

9. The power module (1) according to one of the preceding claims, **characterized in that** the insertion opening (20) is closed by means of a closing element (21), preferably a stopper or a screw.

10. The power module (1) according to one of the preceding claims, **characterized in that** the protective housing (19) is configured to be electrically conductive and electrically connected to the cooling device (7).

11. The power module (1) according to claim 10, **characterized in that** the connecting element (15) is arranged such that protective housing (19) is electrically connected to the cooling device (7) and one of the busbars (10).

12. The power module (1) according to one of the preceding claims, **characterized in that** the cooling device (7) is configured as a load-bearing cooling plate (8) that can be flown through by coolant.

13. The power module (1) according to claim 12, **characterized in that** the energy storage module (5) is arranged on a side of the cooling plate (8) opposite the at least one power semiconductor module (3) and the at least two busbars (10), wherein the cooling plate (8) has a passage (25) for connecting the energy storage module (5) to the at least one power semiconductor module (3).

14. A method for producing a power module (1), in particular for a medium or high voltage converter (2), comprising the method steps:
- providing a power module (1) according to one of claims 1 to 13, at least comprising:
- fastening a protective housing (19), closing off at least the power semiconductor module (3) toward the environment, on the cooling device (7), which protective housing (19) has at least one insertion opening (20) for inserting and fastening a connecting element (15),
- forming a defined charge-reversal path (17) by affixing the connecting element (15) on the predefinable connection position (16) between at least the cooling device (7) and one of the busbars (10) through the insertion opening (20) when the protective housing (19) is closed.

15. The method according to claim 14, **characterized in that**, during or after mounting the connecting element (15), the insertion opening (20) is closed by means of a closing element (21), preferably a stopper or a screw.

16. The method according to claim 15, **characterized in that**, by mounting the connecting element (15), the insertion opening (20) is closed, and the connection position (16) between at least the cooling device (7) and one of the busbars (10) and the protective housing (19) is formed.

17. The method according to one of claims 14 to 16, **characterized in that**, before fastening the protective housing (19), a first electrical examination of the power module (1) is performed by applying a first examination voltage to at least one predefinable insulation route.

18. The method according to claim 17, **characterized in that**, after the first examination and/or after the fastening of the protective housing (19), a second electrical examination of the power module (1) is performed by applying a second examination voltage that is increased relative to the first examination voltage to at least one predefinable insulation route.

19. The method according to one of claims 14 to 18, **characterized in that** between one of the busbars (10) and the cooling device (7) and/or the protective housing (19), a control examination regarding the proper functioning and/or the presence of the connecting element (15) is performed.

## Revendications

1. Module de puissance (1) pour un convertisseur de moyenne ou de haute tension (2), plus particulièrement un convertisseur multi-niveaux modulaire, comprenant :
- au moins un module semi-conducteur de puissance (3),
- au moins un module d'accumulation d'énergie (5),
- au moins un dispositif de refroidissement (7), qui est conçu de manière électro-conductrice,
- au moins deux barres de bus (10), dans lequel
le dispositif de refroidissement (7) est relié avec boîtier de protection (19) protégeant au moins le module semi-conducteur de puissance (3) contre l'environnement, **caractérisé en ce que**
le boîtier de protection (19) comprend au moins une ouverture d'introduction (20) pour l'introduction et la fixation d'un élément de liaison électro-conducteur (15) lorsque le boîtier de protection (19) est fermé,
et, au niveau d'une position de liaison prédéterminée (16), l'élément de liaison électro-conducteur (15) est disposé, pour la formation d'un chemin de charge défini (17), entre au moins le dispositif de refroidissement (7) et une des barres de bus (10).

2. Module de puissance (1) selon la revendication 1, **caractérisé en ce que** l'élément de liaison (15) est conçu de manière amovible, de préférence sous la forme d'un élément de vissage, d'enfichage ou d'encliquetage.

3. Module de puissance (1) selon la revendication 1 ou 2, **caractérisé en ce que** l'élément de liaison (15) présente une section transversale qui est 10 %, de préférence 20 % supérieure à la section transversale minimale nécessaire pour la formation du chemin de charge défini (17) et d'une déviation des courants de décharge parasites.

4. Module de puissance (1) selon l'une des revendications précédentes, **caractérisé en ce qu'**au moins deux modules semi-conducteurs de puissance (3) sont disposés sur au moins deux côtés des barres de bus (10), orientés perpendiculairement sur un plan des barres de bus (10), de préférence de manière superposée.

5. Module de puissance (1) selon l'une des revendications précédentes, **caractérisé en ce que** l'élément de liaison (15) est disposé de façon à relier électriquement au moins une des barres de bus (10) avec le dispositif de refroidissement (7) et l'au moins une autre barre de bus (10) est disposée de manière traversante et isolante électriquement par rapport à celui-ci.

6. Module de puissance (1) selon la revendication 5, **caractérisé en ce que** l'élément de liaison (15) est disposé au centre (23) du plan des barres de bus (10).

7. Module de puissance (1) selon l'une des revendications 1 à 4, **caractérisé en ce qu'**au moins une des barres de bus (10) comprend une patte de raccordement (11) dépassant latéralement pour la mise en contact de l'élément de liaison (15).

8. Module de puissance (1) selon l'une des revendications précédentes, **caractérisé en ce qu'**un élément d'introduction (22), de préférence en forme de canal ou de forme tubulaire, est conçu de façon à s'étendre au moins partiellement de l'ouverture d'introduction (20) du boîtier de protection (19) en direction de la barre de bus (10) la plus proche.

9. Module de puissance (1) selon l'une des revendications précédentes, **caractérisé en ce que** l'ouverture d'introduction (20) est obturée au moyen d'un élément d'obturation (21), de préférence un bouchon ou une vis.

10. Module de puissance (1) selon l'une des revendications précédentes, **caractérisé en ce que** le boîtier de protection (19) est conçu de manière électro-conductrice et est relié électriquement avec le dispositif de refroidissement (7).

11. Module de puissance (1) selon la revendication 10, **caractérisé en ce que** l'élément de liaison (15) est disposé de façon à ce que le boîtier de protection (19) soit relié électriquement avec le dispositif de refroidissement (7) et une des barres de bus (10).

12. Module de puissance (1) selon l'une des revendications précédentes, **caractérisé en ce que** le dispositif de refroidissement (7) est conçu comme une plaque de refroidissement (8) déviant les charges et pouvant être traversée par un fluide de refroidissement.

13. Module de puissance (1) selon la revendication 12, **caractérisé en ce que** le module d'accumulation d'énergie (5) est disposé au niveau d'un côté de la plaque de refroidissement (8) opposé à l'au moins un module semi-conducteur de puissance (3) et aux au moins deux barres de bus (10), dans lequel la plaque de refroidissement (8) comprend une ouverture de passage (25) pour la liaison du module d'accumulation d'énergie (5) avec l'au moins un module semi-conducteur de puissance (3).

14. Procédé de fabrication d'un module de puissance (1), plus particulièrement pour un convertisseur de moyenne ou de haute tension (2), comprenant les étapes suivantes :
- mise à disposition d'un module de puissance (1) selon l'une des revendications 1 à 13, comprenant au moins :
- la fixation d'un boîtier de protection (19), isolant au moins le module semi-conducteur de puissance (3) vis-à-vis de l'environnement, au dispositif de refroidissement (7), qui comprend au moins une ouverture d'introduction (20) pour l'introduction et la fixation d'un élément de liaison (15),
- formation d'un chemin de charge défini (17) par le montage de l'élément de liaison (15) à une position de liaison (16) prédéterminée entre au moins le dispositif de refroidissement (7) et une des barres de bus (10) à travers l'ouverture d'introduction (20) lorsque le boîtier de protection (19) est fermé.

15. Procédé selon la revendication 14, **caractérisé en ce que**, avec ou après le montage de l'élément de liaison (15), l'ouverture d'introduction (20) est obturée au moyen d'un élément d'obturation (21), de préférence un bouchon ou une vis.

16. Procédé selon la revendication 15, **caractérisé en ce que**, grâce au montage de l'élément de liaison (15), l'ouverture d'introduction (20) est obturée et la position de liaison (16) est disposée entre au moins le dispositif de refroidissement (7) et une des barres de bus (10) et le boîtier de protection (19).

17. Procédé selon l'une des revendications 14 à 16, **caractérisé en ce que**, avant la fixation du boîtier de protection (19), un premier test électrique du module de puissance (1) est effectué en appliquant une première tension de test sur au moins une portion d'isolation prédéterminée.

18. Procédé selon la revendication 17, **caractérisé en ce que**, après le premier contrôle et/ou après la fixation du boîtier de protection (19), un deuxième test électrique du module de puissance (1) est effectué en appliquant une deuxième tension de test, augmentée par rapport à la première tension de test, sur au moins la portion d'isolation prédéterminée.

19. Procédé selon l'une des revendications 14 à 18, **caractérisé en ce que**, entre une des barres de bus (10) et le dispositif de refroidissement (7) et/ou le boîtier de protection (19) est effectué un test de contrôle concernant la fonctionnalité et/ou la présence de l'élément de liaison (15).
